# FASCICULE DE BREVET EUROPEEN

(11) **EP 0 533 551 B1**
(45) Date de publication et mention de la délivrance du brevet: **09.08.2000**
(21) Numéro de dépôt: 92402520.8
(22) Date de dépôt: 15.09.1992
(51) Int. Cl.: H01L 21/265, H01L 21/76

(54) **Procédé de fabrication de films minces de matériau semiconducteur**
Verfahren zur Herstellung dünner Schichten aus Halbleitermaterial
Process for manufacturing thin film layers of semiconductor material

(30) Priorité: 18.09.1991 FR 9111491
(43) Date de publication de la demande: 24.03.1993
(73) Titulaire: COMMISSARIAT A L'ENERGIE ATOMIQUE, 75015 Paris (FR)
(72) Inventeur: Bruel, Michel, F-38113 Veurey (FR)
(74) Mandataire: Dubois-Chabert, Guy

(56) Documents cités:
- GB-A- 2 211 991
- US-A- 5 034 343
- APPLIED PHYSICS LETTERS. vol. 55, no. 21, 20 Novembre 1989, NEW YORK US pages 2223 - 2224 J. LI 'novel semiconductor substrate formed by hydrogen ion implantation into silicon.'
- IBM TECHNICAL DISCLOSURE BULLETIN. vol. 29, no. 3, Août 1986, NEW YORK US page 1416 'isolation by inert ion implantation'

## Description

La présente invention concerne un procédé de fabrication de films minces de matériau semiconducteur, préférentiellement applicable à la réalisation de films monocristallins.

On sait que pour réaliser des films minces monocristallins de semiconducteurs il existe plusieurs méthodes et procédés dont la mise en oeuvre est souvent complexe et coûteuse car s'il est relativement aisé de réaliser des films de matériau polycristallin ou amorphe, il est beaucoup plus difficile de réaliser des films monocristallins.

On peut citer comme méthodes de réalisation de films monocristallins certaines des méthodes utilisées pour la fabrication des substrats dits "Silicium sur Isolant", où le but recherché est de fabriquer un film de silicium monocristallin reposant sur un substrat isolé électriquement du film.

Les méthodes d'hétéroépitaxie permettent par croissance cristalline de faire croître un cristal par exemple en silicium en film mince sur un substrat monocristallin d'une autre nature dont le paramètre de maille est voisin de celui du silicium, par exemple : substrat de saphir (Al₂0₃) ou de fluorure de calcium (CaF₂). (Voir réf. 5).

Le procédé dit "SIMOX" (nom couramment utilisé dans la littérature) utilise l'implantation ionique à forte dose d'oxygène dans un substrat de silicium pour créer dans le volume du silicium une couche d'oxyde de silicium séparant un film mince de silicium monocristallin de la masse de substrat. (Voir réf. 1).

D'autres procédés utilisent le principe de l'amincissement d'une plaquette par abrasion mécanochimique ou chimique ; les procédés de cette catégorie les plus performants utilisent en outre le principe de la barrière d'arrêt à la gravure (etch-stop en termes anglo-saxon) qui permet d'arrêter l'amincissement de la plaquette dès que l'épaisseuer requise est atteinte et donc de garantir une homogénéité d'épaisseur. Cette technique consiste par exemple à doper de type p le substrat de type n sur l'épaisseur du film que l'on désire obtenir et à attaquer chimiquement le substrat avec un bain chimique actif pour le silicium de type n et inactif par le silicium de type p. (Voir réf. 2, 3).

On connaît également, par le document Applied Physics Letters, Vol. 55, n° 21, 20.11.89, pp. 2223-2224, un procédé pour la formation d'une région isolante enterrée dans un substrat semiconducteur, comportant la création de microbulles gazeuses par une implantation de protons suivie d'un traitement thermique. Le document GB-A-2 211 991 décrit un procédé d'obtention d'une couche diélectrique ou de haute résistivité, enterrée dans un substrat semiconducteur par implantation ionique. Le procédé comprend une première étape d'implantation d'ions d'hydrogène ou d'un gaz inerte de manière à former des bulles et/ou des vides dans le substrat. On procède à une seconde étape d'implantation au moyen d'ions d'oxygène ou d'azote pour d'abord stabiliser les bulles et/ou les vides dans le substrat, puis pour former une couche d'oxyde ou de nitrure reliant entre elles les bulles et/ou les vides dans le substrat. Ce document enseigne (page 4, lignes 5 à 11) qu'il existe une limite supérieure dans la dose d'ions d'hydrogène ou d'hélium à ne pas dépasser pour éviter que les bulles et/ou les vides créés ne coalescent pour former un défaut continu qui conduirait au détachement de la région supérieure du substrat en silicium. Le document IBM Technical Disclosure Bulletin, Vol. 29, n° 3, Août 1986, p. 1416, décrit un procédé d'implantation d'ions pour réaliser une couche enterrée isolante sous la surface d'un semiconducteur. Les ions implantés sont des ions hydrogène ou de gaz rares, de préférence des ions hydrogène ou hélium.

Les principales applications des films minces monocristallins de semiconducteur sont les substrats Silicium sur Isolant, les membranes autoporteuses de silicium ou de carbure de silicium pour réaliser des masques pour lithographie par rayons X, les capteurs, les cellules solaires, la fabrication de circuits intégrés à plusieurs couches actives.

Les diverses méthodes de réalisation des films minces monocristallins présentent des inconvénients liés aux techniques de fabrication.

Les méthodes d'hétéroépitaxie sont limitées par la nature du substrat ; le paramètre de maille du substrat n'étant pas strictement exact à celui du semiconducteur, le film mince comporte beaucoup de défauts cristallins. En outre ces substrats sont chers et fragiles et n'existent qu'en dimension limitée.

La méthode SIMOX requiert une implantation ionique à très forte dose ce qui nécessite une machine d'implantation très lourde et complexe ; le débit de ces machines est faible et il est difficilement envisageable de l'augmenter dans des proportions notables.

Les méthodes d'amincissement ne sont compétitives du point de vue de l'homogénéité et de la qualité que si elles utilisent le principe de la barrière d'arrêt à la gravure. Malheureusement, la création de cette barrière d'arrêt rend le procédé complexe et peut limiter dans certains cas l'utilisation du film ; en effet si l'arrêt de la gravure est réalisé par dopage de type p dans un substrat de type n, la réalisation éventuelle de dispositifs électroniques dans le film devra s'accommoder de la nature de type p du film.

La présente invention a pour objet un procédé de fabrication de films minces de matériaux semiconducteurs qui permet de s'affranchir des inconvénients précédents sans nécessiter de substrat initial de nature différente de celle du semiconducteur choisi, ni de très fortes doses d'implantation, ni de barrière d'arrêt à la gravure, mais qui permet néanmoins l'obtention d'un film d'épaisseur homogène et contrôlée.

L'invention a donc pour objet un procédé de préparation de films minces de matériau semiconducteur consistant à soumettre une plaquette d'un matériau semiconducteur comportant une face plane dont le plan est soit sensiblement parallèle à un plan cristallographique principal dans le cas où le matériau semiconducteur est parfaitement monocristallin, soit faiblement incliné par rapport à un plan cristallographique principal dans le cas où le matériau est un semiconducteur polycristallin qui est constitué de grains qui présentent tous un même plan cristallographique principal qui est sensiblement parallèle à la surface du semiconducteur, aux trois étapes suivantes :
- une première étape d'implantation par bombardement de la face de ladite plaquette au moyen d'ions créant, dans le volume de ladite plaquette à une profondeur voisine de la profondeur moyenne de pénétrations desdits ions, une couche de microbulles gazeuses délimitant dans le volume de ladite plaquette une région inférieure constituant la masse du substrat et une région supérieure constituant le film mince, les ions étant choisis parmi les ions de gaz rares ou de gaz hydrogène, la dose d'ions implantés étant suffisante pour déclencher thermiquement la coalescence entre les microbulles et induire un clivage de la plaquette en deux parties au cours de la troisième étape de traitement thermique, la température de la plaquette pendant l'implantation étant maintenue au-dessous de la température à laquelle le gaz engendré par les ions implantés peut s'échapper du matériau semiconducteur par diffusion ;
- une deuxième étape de mise en contact intime de la face plane de ladite plaquette avec un raidisseur constitué d'au moins une couche de matériau rigide, cette deuxième étape étant effectueé à une temperature inférieure à celle du traitement thermique de la troisième étape;
- une troisième étape de traitement thermique de l'ensemble de ladite plaquette et dudit raidisseur à une température supérieure à la température à laquelle est réalisé le bombardement ionique et suffisante pour créer par effet de réarrangement cristallin dans ladite plaquette et de pression dans les microbulles une séparation entre le film mince et la masse du substrat, le raidisseur et la face plane de la plaquette étant maintenues en contact intime au cours de cette étape.

L'invention s'applique donc aussi à un matériau semiconducteur polycristallin à condition que les grains constituant ce dernier présentent tous un plan cristallographique principal, (ce plan ayant les mêmes indices par exemple (1,0,0) pour tous les grains du semiconducteur) sensiblement parallèle à la surface du semiconductuer. On peut citer par exemple pour ces matériaux semiconducteur le ZMRSOI (ZMR = Zone-Melting-Recrystallization) (voir réf. 4). On entend par étape d'implantation aussi bien une étape unique d'implantation qu'une succession d'implantations à des doses et/ou à des énergies et/ou avec des ions qui peuvent être différents.

Selon une variante de mise en oeuvre du procédé, objet de l'invention, il peut être avantageux de réaliser l'implantation des ions dans un matériau semiconducteur à travers une ou plusieurs couches de matériaux, ces couches "encapsulantes" étant choisies de façon à ce que les ions la traversent et pénètrent dans le semiconducteur. A titre d'exemple, ces couches encapsulantes peuvent être utilisées comme moyen de réduire la pénétration des ions dans le semiconducteur pour fabriquer des membranes plus fines ou comme moyen de protéger le semiconducteur de contaminations éventuelles ou encore comme moyen de contrôle de l'état physico-chimique de la surface du semiconducteur. Lorsque le substrat constituant la plaquette est du silicium, il peut être avantageux de choisir une couche encapsulante constituée d'oxyde de silicium thermique d'épaisseur par exemple comprise entre 25 et 500 nm. Ces couches encapsulantes peuvent être conservées ou enlevées après l'étape d'implantation.

Conformément à l'invention, la température de la plaquette sur laquelle on fait l'implantation d'ions est contrôlée durant l'opération de façon à ce qu'elle reste en dessous de la température critique à laquelle le gaz engendré par l'ion implanté diffuse rapidement et s'échappe du semiconducteur. A titre d'exemple, cette température critique est d'environ 500°C pour une implantation d'hydrogène dans du silicium. Au-dessus de cette température précédente, le procédé devient inefficace en raison de l'absence de formation de microbulles. Pour le silicium on choisira préférentiellement une température d'implantation comprise entre 20°C et 450°C.

Lors de l'étape du traitement thermique de l'ensemble de la plaquette et de son raidisseur, se produit un réarrangement cristallin après le désordre créé par l'implantation ionique elle même. La séparation entre le film et le substrat est due à la fois au réarrangement cristallin et à la coalescence des bulles qui engendrent des macrobulles tous deux engendrés lors de l'étape de traitement thermique. Sous l'effet de la pression du gaz à l'intérieur de ces bulles, la surface du semiconducteur est soumise à des tensions importantes. Si l'on veut éviter une déformation de la surface et la formation de cloques (blisters en terminologie anglo-saxonne) correspondant aux macrobulles formées, il faut impérativement compenser ces tensions. En effet, les cloques précédentes peuvent éclater avant que les macrobulles n'aient atteint leur pleine croissance et qu'elles aient coalescé entre elles. C'est la raison pour laquelle si l'on veut recueillir un film continu de semiconducteur, il est nécessaire de compenser les contraintes qui apparaissent pendant la phase du traitement thermique. Conformément à l'invention, cette compensation intervient par mise en contact intime de la surface de la plaquette de semiconducteur avec un raidisseur. Le rôle de ce raidisseur est de par son contact avec la surface et ses propriétés mécaniques de compenser l'effet des tensions engendrées par les macrobulles. Le film de semiconducteur peut ainsi rester plan et intact pendant toute la phase du traitement thermique jusqu'au clivage final.

Selon l'invention, le choix de la méthode de fabrication de ce raidisseur et de sa nature sont faites en fonction de chaque application visée pour le film mince. Par exemple, si l'application visée est la réalisation d'un substrat de silicium sur isolant, le raidisseur peut être constitué avantageusement d'une plaquette de silicium recouverte d'au moins une couche diélectrique telle qu'une couche de nitrure ou une couche d'oxyde, le diélectrique du raidisseur étant mis en contact intime avec la plaquette à partir de laquelle on veut réaliser le film, la plaquette comportant ou non une couche encapsulante par exemple de l'oxyde de silicium.

Le raidisseur peut être soit rapporté sur la plaquette, soit réalisé sur la plaquette de semiconducteur à l'aide de techniques telles que l'évaporation, la pulvérisation, le dépôt chimique en phase vapeur, assisté ou non par plasma ou par photons, dès lors que l'épaisseur choisie pour le raidisseur est modérée, c'est-à-dire de l'ordre de quelques micromètres à quelques dizaines de micromètres.

On entend par contact intime une contact obtenu par pression du raidisseur sur la plaquette par exempte par une pression de type électrostatique et/ou par un contact de type adhérent.

Ainsi, conformément à l'invention, ce même raidisseur peut être aussi bien collé à la plaquette de semiconducteur soit par une substance adhésive à la fois au raidisseur et à la plaquette soit, si l'on ne souhaite pas l'utilisation de substance adhésive, par l'effet d'une préparation préalable d'au moins une des surfaces à coller et d'un traitement thermique et/ou électrostatique assorti éventuellement d'un choix de pressions pour favoriser les liaisons interatomiques entre le raidisseur et la plaquette de semiconducteur. L'application du raidisseur sur la plaquette peut aussi être réalisée à l'aide d'une pression électrostatique.

Pour les applications concernant la fabrication de membranes autoporteuses, il est judicieux de choisir la nature du raidisseur telle que l'on puisse facilement et sélectivement séparer le raidisseur du film. A titre indicatif, pour réaliser une membrane de silicium monocristalllin on peut par exemple choisir un raidisseur en oxyde de silicium que l'on élimine ensuite dans un bain d'acide fluorhydrique après l'étape de traitement thermique du procédé.

Selon un mode de mise en oeuvre du procédé objet de l'invention, le choix des températures de déroulement de l'étape de mise en contact intime de la plaquette et du raidisseur et de l'étape de traitement thermique répond aux conditions suivantes. La réalisation de la mise en place du raidisseur sur la plaquette ne fait pas subir à celles-ci une température qui serait de nature à déclencher les processus de l'étape de traitement thermique. Pour cette raison, suivant ce mode de mise en oeuvre de l'invention, on réalise l'étape de mise en contact intime du procédé à une température inférieure à celle de l'étape du traitement thermique. Ce dernier traitement thermique est réalisé, conformément à ce mode de mise en oeuvre de l'invention à une température à laquelle le réarrangement cristallin et la coalescence des bulles peuvent effectivement avoir lieu. A titre d'exemple, dans Le cas du silicium, une température supérieure à 500°C environ est nécessaire pour que le réarrangement cristallin et la coalescence des bulles puissent avoir lieu avec une cinétique suffisante.

Dans la mise en oeuvre du procédé, objet de l'invention, les ions utilisés pour l'implantation par bombardement sont le plus souvent des ions H⁺ mais ce choix ne doit pas cependant être considéré comme limitatif. En effet, le principe de la méthode est applicable avec des ions moléculaires d'hydrogène ou avec des ions de gaz rares tels que, hélium, néon, krypton et xénon, utilisés isolément ou en combinaison. Pour les applications industrielles du procédé, objet de l'invention, les semiconducteurs du groupe IV sont indiqués de façon préférentielle et l'on peut recourir par exemple au silicium, au germanium, au carbure de silicium ainsi qu'aux alliages silicium/germanium.

De toute façon l'invention sera mieux comprise en se référant à la description qui suit d'un exemple de mise en oeuvre qui sera décrit à titre illustratif et non limitatif en se référant aux figures 1 à 4 suivantes sur lesquelles :
- la figure 1 montre le profil de concentration des ions hydrogènes en fonction de la profondeur de pénétration ;
- la figure 2 montre la plaquette de semiconducteur monocristallin utilisé dans l'invention comme origine du film mince monocristallin, en coupe, soumis à un bombardement d'ions H⁺, et à l'intérieur duquel est apparue une couche de microbulles de gaz engendrée par les particules implantées ;
- la figure 3 représente la plaquette de semiconducteur décrite par la figure 2 recouverte d'un raidisseur ;
- la figure 4 représente l'ensemble de la plaquette de semiconducteur et du raidisseur décrit sur la figure 3 à la fin de la phase de traitement thermique quand le clivage entre le film et la masse du substrat a eu lieu.

L'exemple qui sera décrit maintenant en se référant aux figures précédentes concerne la fabrication d'un film mince dans une plaquette de silicium monocristallin à l'aide d'implantations d'ions H⁺.

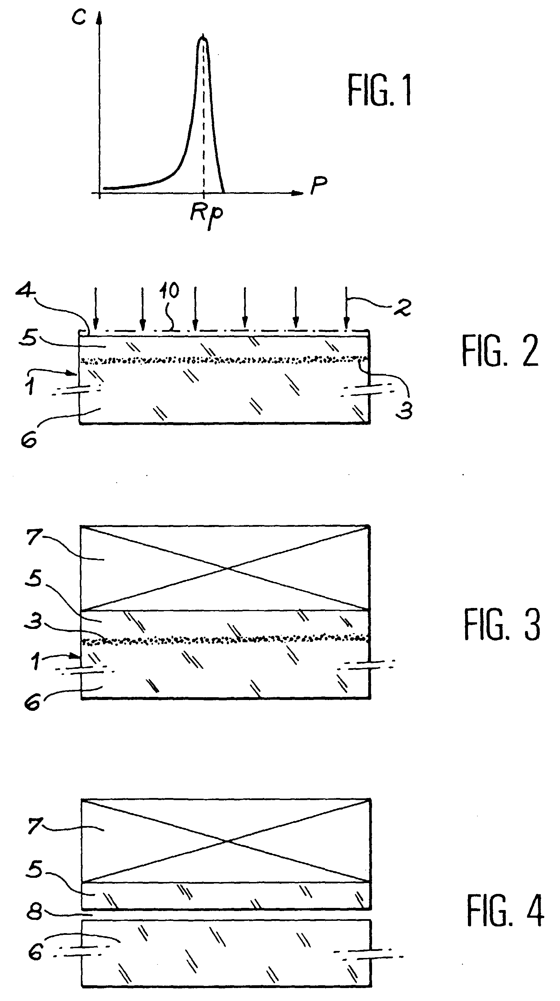

L'implantation d'ions H⁺ (protons) à 150 kev dans une plaquette de silicium monocristallin dont la surface correspond à un plan cristallographique principal par exemple, un plan (1,0,0) se traduit pour les faibles doses d'implantation (<10¹⁶cm⁻²) par un profil de concentration C en hydrogène en fonction de la profondeur P, présentant un maximum de concentration pour une profondeur Rp, tel que représenté figure 1. Dans le cas d'une implantation de protons dans du silicium, Rp vaut environ 1,25 micromètres.

Pour les doses de l'ordre de 10¹⁶cm⁻² les atomes d'hydrogène implantés commencent à former des bulles, qui se répartissent au voisinage d'un plan parallèle à la surface. Le plan de la surface correspond à un plan cristallographique principal et il en est donc de même pour le plan des microbulles qui est donc par conséquent un plan de clivage.

Pour une dose implantée de >10¹⁶cm⁻² (par exemple de 5.10¹⁶cm², on peut déclencher thermiquement la coalescence entre les bulles induisant un clivage du silicium en deux parties, une couche supérieure de 1,2 micromètre d'épaisseur (le film mince) et la masse du substrat.

L'implantation d'hydrogène est un exemple avantageux car le processus de freinage de cet ion dans le silicium est essentiellement de l'ionisation (freinage électronique), le freinage de type nucléaire avec déplacements atomiques n'intervenant que sur la fin du parcours. C'est pourquoi on crée très peu de défauts dans la couche superficielle du silicium et que les bulles se concentrent au voisinage de la profondeur Rp (profondeur du maximum de concentration) sur une épaisseur faible. Ceci permet d'obtenir l'efficacité de la méthode pour des doses implantées moyennes (5.10¹⁶cm⁻²), d'obtenir après séparation de la couche superficielle une surface de faible rugosité.

L'utilisation du procédé de l'invention permet en outre de choisir l'épaisseur du film mince dans une large gamme d'épaisseur en choisissant l'énergie d'implantation. Cette propriété est d'autant plus vraie que l'ion implanté présente un numéro atomique z faible. A titre d'exemple, on donne sur le tableau suivant l'épaisseur du film que l'on peut obtenir pour diverses énergies d'implantation des ions H⁺ (z=1).

| | | | | | | | |
|---|---|---|---|---|---|---|---|
| Energie des ions H⁺ en keV | 10 | 50 | 100 | 150 | 200 | 500 | 1000 |
| Epaisseur du film en µm | 0,1 | 0,5 | 0,9 | 1,2 | 1,6 | 4,7 | 13,5 |

Sur la figure 2 on voit la plaquette de semiconducteur 1 recouverte éventuellement d'une couche encapsulante 10 soumis à un bombardement ionique 2 d'ions H⁺ à travers la face plane 4 qui est parallèle à un plan cristallographique principal ; on voit la couche 3 de microbulles parallèle à la face 4. La couche 3 et la face 4 délimitent le film mince 5. Le reste 6 du substrat semiconducteur constitue la masse du substrat.

Sur la figure 3 on voit le raidisseur 7 qui a été mis en contact intime avec la face 4 de la plaquette 1 de semiconducteur. Dans un exemple de mise en oeuvre intéressant de l'invention, l'implantation d'ions dans le matériau est réalisée à travers une couche encapsulante (10) d'oxyde de silicium thermique et le raidisseur (7) est constitué d'une plaquette de silicium recouverte d'au moins une couche diélectrique.

Un autre exemple de mise en oeuvre utilise une pression électrostatique pour fixer le raidisseur sur le matériau semiconducteur. Dans cet exemple, on choisit un raidisseur en silicium comportant une couche d'oxyde de silicium de 500 nm (5000 Å) d'épaisseur par exemple. On met la face plane de la plaquette en contact avec l'oxyde du raidisseur et l'on applique entre la plaquette et le raidisseur une différence de potentiel de quelques dizaines de volts. Les pressions obtenues sont alors de l'ordre de quelques 10⁵ à 10⁶ Pascal.

Sur la figure 4 on voit le film 5 solidaire du raidisseur 7 séparé par l'espace 8 de la masse du substrat 6.

Les références indiquées dans le présent texte sont les suivantes :
(1) SIMOX SOI for Integrated Circuit Fabrication par Hon Wai Lam, IEEE Circuits and Devices Magazine, Juillet 1987, pp. 6-11.
(2) Silicon on Insulator Wafer Bonding Wafer Thinning Technological Evaluations par Haisma, Spierings, Biermann et Pals, Japanese Journal of Applied Physics, vol. 28, n° 8, Août 1989, pp. 1426-1443.
(3) Bonding of silicon wafers for silicon on insulator, par Maszara, Goetz, Caviglia et McKitterick, Journal of Applied Physic 64 (10) 15 Nov. 1988, pp. 4943-4950.
(4) Zone melting recrystallization silicon on insulator technology par Bor Yeu Tsaur, IEEE Circuits and Devices Magazine, Juillet 1987, pp. 12-16.
(5)1986 IEEE SOS/SOI Technology Workshop, Sept. 30-Oct. 2, 1986, South seas plantation resort and yacht Harbour, Captiva Island, Floride.

## Revendications

1. Procédé de préparation de films minces de matériau semiconducteur consistant à soumettre une plaquette (1) d'un matériau semiconducteur comportant une face plane dont le plan est soit sensiblement parallèle à un plan cristallographique principal dans le cas où le matériau semiconducteur est parfaitement monocristallin, soit faiblement incliné par rapport à un plan cristallographique principal dans le cas où le matériau est un semiconducteur polycristallin qui est constitué de grains qui présentent tous un même plan cristallographique principal qui est sensiblement parallèle à la surface du semiconducteur, aux trois étapes suivantes :
- une première étape d'implantation par bombardement (2) de la face (4) de ladite plaquette (1) au moyen d'ions créant, dans le volume de ladite plaquette (1) à une profondeur voisine de la profondeur moyenne de pénétration desdits ions, une couche (3) de microbulles gazeuses délimitant dans le volume de ladite plaquette (1) une région inférieure (6) constituant la masse du substrat et une région supérieure (5) constituant le film mince, les ions étant choisis parmi les ions de gaz rares ou de gaz hydrogène, la dose d'ions implantés étant suffisante pour déclencher thermiquement la coalescence entre les microbulles et induire un clivage de la plaquette (1) en deux parties au cours de la troisième étape de traitement thermique, la température de la plaquette (1) pendant l'implantation étant maintenue au-dessous de la température à laquelle le gaz engendré par les ions implantés peut s'échapper du matériau semiconducteur par diffusion ;
- une deuxième étape de mise en contact intime de la face plane (4) de ladite plaquette (1) avec un raidisseur (7) constitué d'au moins une couche de matériau rigide ;
- une troisième étape de traitement thermique de l'ensemble de ladite plaquette (1) et dudit raidisseur (7) à une température supérieure à la température à laquelle est réalisé le bombardement ionique (2) et suffisante pour créer par effet de réarrangement cristallin dans ladite plaquette (1) et de pression dans les microbulles une séparation entre le film mince (5) et la masse du substrat (6), le raidisseur (7) et la face plane (4) de la plaquette (1) étant maintenues en contact intime au cours de cette étape.

2. Procédé de préparation de films minces selon la revendication 1, caractérisé en ce que l'étape d'implantation des ions dans le matériau semiconducteur est effectuée à travers une ou plusieurs couches de matériaux de nature et d'épaisseur telles qu'ils puissent être traversés par les ions.

3. Procédé de fabrication de films minces selon la revendication 1, caractérisé en ce que le semiconducteur est un semiconducteur à liaisons covalentes du groupe IV.

4. Procédé de fabrication de films minces selon l'une quelconque des revendications 1 à 3, caractérisé en ce que le semiconducteur est le silicium, l'ion implanté est un ion de gaz hydrogène, la température d'implantation est comprise entre 20°C et 450°C et la température de l'étape de traitement thermique est supérieure à 500°C.

5. Procédé de fabrication de films minces selon la revendication 2, caractérisé en ce que l'implantation est réalisée à travers une couche encapsulante d'oxyde de silicium thermique.

6. Procédé de fabrication de films minces selon l'une des revendications 2 ou 5, caractérisé en ce que le raidisseur est une plaquette de silicium recouverte d'au moins une couche d'oxyde de silicium.

7. Procédé de fabrication de films minces selon la revendication 1, caractérisé en ce que l'étape de mise en contact intime de la face plane (4) de ladite plaquette avec un raidisseur (7) est réalisée par application d'une pression électrostatique.

8. Procédé de fabrication de films minces selon la revendication 1, caractérisé en ce que le raidisseur est déposé par l'une ou plusieurs des techniques comprises dans le groupe : évaporation, dépôt chimique en phase vapeur avec ou sans assistance plasma ou assistance photonique, pulvérisation.

9. Procédé de fabrication de films minces selon la revendication 1, caractérisé en ce que le raidisseur est collé à la dite plaquette au moyen d'une substance adhésive.

10. Procédé de fabrication de films minces selon la revendication 1, caractérisé en ce que le raidisseur est rendu adhérent à la plaquette par un traitement favorisant les liaisons interatomiques.

## Claims

1. Process for the preparation of thin films of semiconductor material consisting of subjecting a semiconductor material wafer having a planar face, whose plane is either substantially parallel to a principle crystallographic plane in the case where the semiconductor material is perfectly monocrystalline, or is slightly inclined with respect to a principle crystallographic plane in the case where the material is a polycrystalline semiconductor constituted by grains all having the same principle crystallographic plane substantially parallel to the surface of the semiconductor, to the three following stages:
- a first stage of implantation by bombardment (2) of the face (4) of said wafer (1) by means of ions creating, in the volume of said wafer at a depth close to the average penetration depth of said ions, a layer (3) of gaseous microbubbles defining in the volume of said wafer a lower region (6) constituting the mass of the substrate and an upper region (5) constituting the thin film, the ions being chosen among ions of rare gases or hydrogen gas, the implanted ion dose being adequate to thermally initiate coalescence between the microbubbles and for inducing a cleaving of the wafer (1) into two parts during the third heat treatment stage, the temperature of the wafer (1) during implantation being kept below the temperature at which the gas produced by the implanted ions can escape from the semiconductor material by diffusion,
- a second stage of intimately contacting the planar face (4) of said wafer (1) with a stiffener (7) constituted by at least one rigid material layer, said second stage being performed at a temperature lower than that of the heat treatment of the third stage,
- a third stage of heat treating the complete wafer (1) and said stiffener (7) at a temperature above the temperature at which ion bombardment (2) takes place and adequate for creating by a crystalline rearrangement effect in said wafer (1) and pressure in the microbubbles a separation between the thin film (5) and the mass of the substrate (6), the stiffener (7) and the planar face (4) of the wafer (1) being kept in intimate contact during this stage.

2. Process for the preparation of thin films according to claim 1, characterized in that the stage of implanting ions in the semiconductor material takes place through one or more layers of materials having a nature and thickness such that they can be traversed by the ions.

3. Process for the production of thin films according to claim 1, characterized in that the semiconductor has covalent bonds of the IV group.

4. Process for the production of thin films according to any one of the claims 1 to 3, characterized in that the semiconductor is silicon, the implanted ion is a hydrogen gas ion, the implantation gas temperature is between 20 and 450°C and the temperature of the third heat treatment stage exceeds 500°C.

5. Process for the production of thin films according to claim 2, characterized in that implantation takes place through an encapsulating thermal silicon oxide layer.

6. Process for the production of thin films according to one of the claims 2 or 5, characterized in that the stiffener is a silicon wafer covered by at least one silicon oxide layer.

7. Process for the production of thin films according to claim 1, characterized in that the second stage of intimately contacting the planar face (4) of said wafer with a stiffener (7) takes place by applying an electrostatic pressure.

8. Process for the production of thin films according to claim 1, characterized in that the stiffener is deposited by one or more methods from within the group evaporation, chemical vapour deposition with or without plasma assistance or photon assistance or sputtering.

9. Process for the production of thin films according to claim 1, characterized in that the stiffener is bonded to said wafer by means of an adhesive substance.

10. Process for the production of thin films according to claim 1, characterized in that the stiffener is made to adhere to the wafer by a treatment favouring interatomic bonds.

## Patentansprüche

1. Verfahren zur Herstellung dünner Schichten aus Halbleitermaterial, darin bestehend, eine Platte (1) aus einem Halbleitermaterial mit einer planen Fläche, deren Ebene entweder, falls das Halbleitermaterial vollkommen monokristallin ist, im wesentlichen parallel zu einer kristallographischen Hauptfläche ist oder in Bezug auf eine kristallographische Hauptfläche leicht geneigt ist, falls das Material ein polykristalliner Halbleiter ist, der durch Körner gebildet wird, die alle eine gleiche kristallographische Hauptfläche aufweisen, die im wesentlichen parallel zu der Oberfläche des Halbleiters ist, der folgenden drei Schritten auszusetzen:
- einen ersten Schrift zur Implantation der Fläche (4) der genannten Platte (1) durch Beschuss mit Ionen (2), was in dem Volumen der genannten Platte (1) in einer ungefähr der mittleren Eindringtiefe dieser Ionen entsprechenden Tiefe zur Bildung einer Schicht (3) aus Mikrogasblasen führt, die in dem Volumen der Platte (1) einen unteren Bereich (6) abgrenzen, der die Masse des Substrats bildet und einen oberen Bereich (5), der die dünne Schicht bildet wobei die Ionen zwischen den Edelgas- oder den Wasserstoffgas-Ionen ausgewählt werden, die Dosis der implantierten Ionen ausreicht, um die Koaleszenz zwischen den Mikroblasen thermisch auszulösen und während des dritten, thermischen Behandlungsschritts eine Spaltung der Platte in zwei Teile zu bewirken, wobei die Temperatur der Platte (1) während der Implantation unter der Temperatur gehalten wird, bei der das durch die implantierten Ionen erzeugte Gas durch Diffusion aus dem Halbleitermaterial entweichen kann;
- einen zweiten Schritt zur Herstellung eines innigen Kontakts der planen Fläche (4) der genannten Platte (1) mit einer Versteifung (7), gebildet durch wenigstens eine Schicht aus steifem Material;
- einen dritten Schritt zur thermischen Behandlung der Einheit aus der Platte (1) und der Versteifung (7) bei einer Temperatur, die höher ist als die Temperatur, bei der der Ionenbeschuss (2) durchgeführt wurde und die ausreicht, um durch einen kristallinen Umlagerungseffekt und durch den Druck in den Mikroblasen eine Trennung zwischen der dünnen Schicht (5) und der Masse des Substrats (6) herbeizuführen, wobei die Versteifung (7) und die plane Fläche (4) der Platte (1) während dieses Schritts in innigem Kontakt gehalten werden.

2. Verfahren nach Anspruch 1, dadurch gekennzeichnet, dass in dem Implantationsschritt die Ionen in dem Halbleitermaterial durch eine oder mehrere Materialschichten hindurch implantiert werden, deren Art und Dicke so ist, dass sie von den Ionen durchquert werden können.

3. Verfahren nach Anspruch 1, dadurch gekennzeichnet, dass der Halbleiter ein Halbleiter mit kovalenten Bindungen der Gruppe IV ist.

4. Verfahren nach einem der Ansprüche 1 bis 3, dadurch gekennzeichnet, dass der Halbleiter das Silizium ist das implantierte Ion ein Wasserstoffgas-Ion ist, die Implantationstemperatur zwischen 20°C und 450°C enthalten ist und die Temperatur des Wärmebehandlungsschritts höher als 500°C ist.

5. Verfahren nach Anspruch 2, dadurch gekennzeichnet, dass die Implantation durch eine thermische Einkapselungsschicht aus Siliziumoxid hindurch erfolgt.

6. Verfahren nach einem der Ansprüche 2 oder 5, dadurch gekennzeichnet, dass die Versteifung eine mit wenigstens einer Siliziumoxidschicht überzogene Siliziumplatte ist.

7. Verfahren nach Anspruch 1, dadurch gekennzeichnet, dass der Schritt zur Herstellung des innigen Kontakts der planen Fläche (4) der genannten Plane mit der Versteifung (7) durch Anwendung eines elektrostatischen Drucks realisiert wird.

8. Verfahren nach Anspruch 1, dadurch gekennzeichnet, dass die Versteifung durch eine oder mehrere der Techniken abgeschieden wird, die enthalten sind in der Gruppe: Aufdampfung, chemische Gasphasenabscheidung mit oder ohne Plasmaunterstützung oder Photonenunterstützung, Sputtern.

9. Verfahren nach Anspruch 1, dadurch gekennzeichnet, dass die Versteifung mittels einer haftenden Substanz an der genannten Platte festgeklebt wird.

10. Verfahren nach Anspruch 1, dadurch gekennzeichnet, dass die Versteifung durch eine Behandlung an der Platte haftet, die die interatomaren Bindungen begünstigt
